Europäisches Patentamt

European Patent Office

Office européen des brevets

(19)

(11) EP 0 944 171 A1

(12) # DEMANDE DE BREVET EUROPEEN

(43) Date de publication:
22.09.1999 Bulletin 1999/38

(51) Int Cl.⁶: **H03L 7/099**, H03L 7/10

(21) Numéro de dépôt: **99200720.3**

(22) Date de dépôt: **10.03.1999**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **17.03.1998 FR 9803246**

(71) Demandeur: **Koninklijke Philips Electronics N.V.**
**5621 BA Eindhoven (NL)**

(72) Inventeur: **Rousselin, Samuel**
**75008 Paris (FR)**

(74) Mandataire: **Chaffraix, Jean**
**Société Civile S.P.I.D.**
**156, Boulevard Haussmann**
**75008 Paris (FR)**

(54) **Appareil électronique comportant un synthétiseur de fréquence et procédé pour régler un synthétiseur de fréquence**

(57) Cet appareil comporte un synthétiseur de fréquence formé essentiellement d'un asservissement de phase pour agir sur un oscillateur (22) à partir d'un détecteur de phase (26). Pour être sûr que l'oscillateur oscille dans la gamme de fréquence qui lui est impartie, on a ajouté des condensateurs commutables (38, 39, 40 et 41). Ces condensateurs sont insérés dans le circuit oscillant de l'oscillateur (22) en fonction d'une quantité numérique contenue dans un compteur-décompteur (77).

Application : radio téléphone portable

FIG.2

**EP 0 944 171 A1**

## Description

La présente invention concerne un appareil électronique muni d'un synthétiseur de fréquences destiné à synthétiser des signaux dans une gamme de fréquences, synthétiseur comportant :

- un oscillateur variable à commande par grandeur électrique dont la valeur varie d'une valeur minimum vers une valeur maximum,
- une série d'éléments de modifications de l'oscillation dudit oscillateur.

L'invention concerne aussi un procédé pour régler un synthétiseur de fréquences.

De tels appareils sont bien connus et trouvent de nombreuses applications, notamment dans le domaine des télécommunications. Par exemple, ces appareils sont des dispositifs téléphoniques portables pouvant communiquer sur un ensemble de canaux fréquentiels dont les porteuses sont fixées à l'aide de synthétiseurs de fréquences.

Un problème qui se pose avec de tel appareils et qui est dû surtout au fait que l'on exige des gammes de fréquences de plus étendues, est qu'il devient difficile, en fin de fabrication, d'obtenir que la gamme de fréquences du synthétiseur cadre parfaitement avec la gamme de fréquences exigée. Le cadrage peut aussi dériver avec le vieillissement des composants du synthétiseur, et les changements de température.

Un circuit intégré immatriculé MC13110 fabriqué par MOTOROLA propose de rajouter des capacités sur le circuit résonnant de l'oscillateur variable dont la grandeur de commande est une tension.

La présente invention propose un appareil du genre mentionné dans le préambule dans lequel on a prévu des moyens pour déterminer l'insertion ou la suppression, dans le circuit dudit oscillateur à commande, de telles capacités ou autres éléments pouvant modifier la fréquence d'oscillation dudit oscillateur.

Pour cela, un tel appareil est remarquable en ce qu'il est muni, en outre, d' un organe de commande pour mettre en circuit les éléments de modification en fonction de l'évolution de ladite grandeur électrique.

L'idée de l'invention est de surveiller la grandeur de commande de l'oscillateur ou une réplique de cette grandeur de commande et d'insérer ou d'enlever les éléments de modification lorsqu'on estime que cette valeur va vers des valeurs de butée incompatibles avec un bon fonctionnement de l'oscillateur.

La description suivante, faite en regard des dessins ci-annexés, le tout donné à titre d'exemple non limitatif, fera bien comprendre comment l'invention peut être réalisée.

La figure 1 montre un appareil conforme à l'invention.

La figure 2 montre le détail de réalisation de l'organe de gestion que comporte l'appareil de la figure 1.

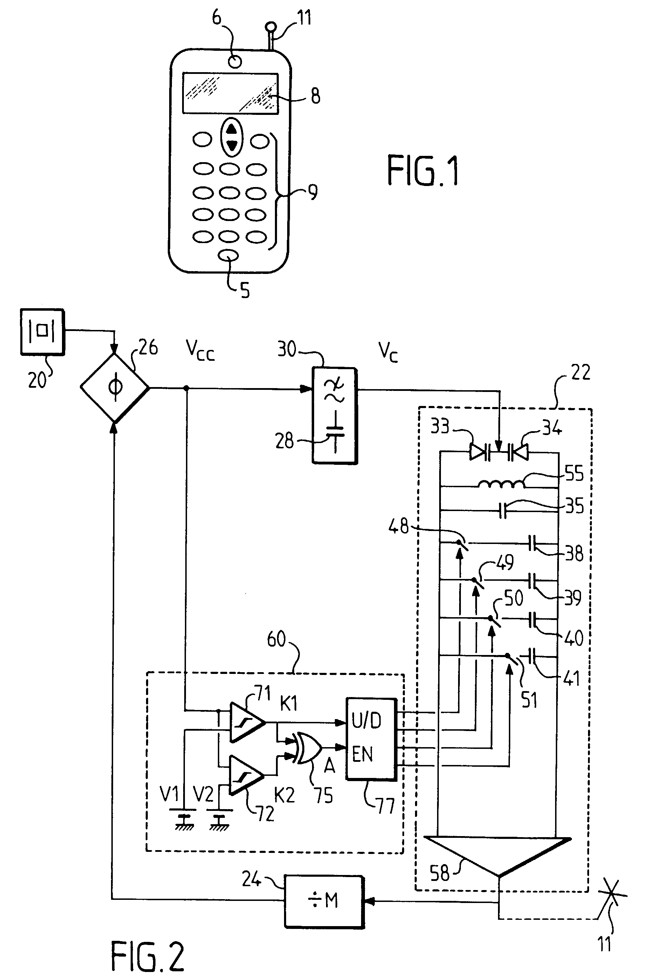

A la figure 1, on représenté un appareil électronique conforme à l'invention. Dans le cadre de l'exemple décrit, c'est un appareil téléphonique sans fil du genre CT0 ou autres. Il est composé d'un microphone 5, d'un écouteur ou haut-parleur 6, d'un écran 8, d'un clavier 9 et d'une antenne 11. Cet appareil se raccorde à sa base, non représentée sur les figures, en utilisant un des canaux prédéfinis selon le pays ou selon leur degré d'occupation. Ces canaux sont définis par un synthétiseur de fréquences dont le schéma est montré en figure 2.

La référence 20 à la figure 2 représente le circuit de fréquence de référence constitué à partir d'un quartz selon la pratique usuelle. La référence 22 est l'oscillateur VCO, c'est-à-dire que la fréquence de cet oscillateur dépend d'une tension. La fréquence du signal de sortie de cet oscillateur 22 est divisée, par un diviseur de fréquence 24, avant d'être comparée avec celle du signal de sortie du circuit de référence 20. Cette comparaison est effectuée par un circuit de mesure d'erreur de phase 26 qui fournit une tension $V_{cc}$. Ce circuit de mesure d'erreur de phase 26 est du type connu sous le nom de « pompe de charge ». On trouvera dans le brevet des Etats-Unis d'Amérique N°4 322 643 la description d'un tel circuit. Ce circuit charge et décharge un condensateur 28 compris dans le filtre passe-bas de la boucle d'asservissement de l'oscillateur 22. La tension issue de ce filtre est appliquée à l'entrée pour la commande de fréquence de l'oscillateur 22. Cette entrée de commande est constituée par les cathodes de deux diodes à capacité variable 33 et 34. Les anodes de ces deux diodes sont reliées aux armatures d'un premier condensateur 35, qui peut être considéré comme le condensateur regroupant les capacités parasites venant se mettre en parallèle sur le montage de ces deux diodes 33 et 34. Différents éléments de modification de l'oscillation constitués ici par des condensateurs 38, 39, 40 et 41 peuvent aussi se mettre en parallèle sur ce montage des deux diodes au moyen de dispositifs interrupteurs 48, 49, 50 et 51. Une bobine de self induction 55 complète le circuit oscillant de l'oscillateur 22. Un circuit actif 58 assure l'oscillation qui peut être transmise à l'antenne 11 soit directement, soit par l'intermédiaire d'une chaîne d'amplification comportant un ou plusieurs étages, avec éventuellement un ou plusieurs changements de fréquence par mélange, ou servir d'oscillateur local pour le récepteur des ondes captées par cette même antenne 11. Les différents condensateurs précités 38, 39, 40 et 41 permettent pour une tension $V_c$ variant de V1 à V2 de caler l'oscillation de l'oscillateur 22 dans la gamme de fréquences exigée.

En fin de fabrication ou à cause du vieillissement de l'appareil, ou à cause de variations de température, il peut arriver que le synthétiseur soit incapable de couvrir toute la gamme de fréquences qu'on attend de lui.

Conformément à l'invention, il est prévu un organe de commande 60 pour pouvoir caler le synthétiseur sur la gamme de fréquence qui lui est impartie, en agissant sur les différents dispositifs interrupteurs 48, 49, 50 et 51. Cet organe 60 est composé de deux comparateurs 71 et 72 pour comparer la tension $V_{CC}$ avec les valeurs V1 et V2 respectivement. Ces circuits comparateurs, présentant une certaine hystérésis, en coopération avec une porte OU-EXCLUSIF 75 fournissant un signal A sont utilisés pour l'incrémentation ou la décrémentation d'un compteur-décompteur 77. Les comparateurs 71 et 72 fournissent respectivement des signaux K1 et K2. Les valeurs V1 et V2 sont telles que :

$$V_{min} < V1 < V2 < V_{MAX}$$

$V_{min}$ et $V_{MAX}$ sont les valeurs minimum et maximum précitées, V1 et V2 sont des valeurs qui sont proches de $V_{min}$ et $V_{MAX}$ et sont donc les valeurs qui déclenchent la mise en circuit ou non des condensateurs 38, 39, 40 et 41.
Le tableau ci-dessous explicite le fonctionnement de cet organe.

| $V_{CC}$ | K1 | K2 | A | Commentaires. |
|---|---|---|---|---|
| <V1, <V2 | 0 | 0 | 1 | Le compteur-décompteur 77 est mis en position de comptage. |
| <V2, ≥V1 | 1 | 0 | 0 | Etat d'équilibre. |
| >V2, >V1 | 1 | 1 | 1 | Le compteur-décompteur 77 est mis en position de décomptage. |

Les condensateurs ont des valeurs C38, C39, C40 et C41 double l'une de l'autre telles que :

C38 = 1.CO
C39 = 2.CO
C40 = 4.CO
C41 = 8.CO

de sorte que toute les valeurs de 0.CO à 15.CO sont obtenues lorsque le contenu du compteur-décompteur 77 varie de 0 à 15. CO est l'unité de base pour ces différents condensateurs. Le signal K1 est appliqué à l'entrée U/D du compteur-décompteur 77 pour le mettre en comptage ou en décomptage. Le signal A provoque l'évolution du contenu de ce compteur-décompteur 77.

Il va de soi que l'on peut utiliser en tant qu'éléments de modification des éléments de self induction sans sortir du cadre de l'invention.

Pour régler un tel synthétiseur comportant :

- un oscillateur à commande par grandeur électrique dont la valeur varie d'une valeur minimum vers une valeur maximum,
- une série d'éléments de modifications de l'oscillation,
- un oscillateur de référence,
- un organe de mesure d'erreur pour comparer le signal de sortie dudit oscillateur à commande avec le signal de sortie dudit oscillateur de référence et pour former une grandeur d'erreur,

l'invention propose en fait un procédé comportant les étapes suivantes :

- prélèvement de la valeur du signal de sortie de l'organe de mesure
- comparaison de cette valeur avec lesdites valeurs minimum et maximum,
- insertion d'éléments lorsque ladite comparaison indique une valeur au-delà des valeurs minimum et maximum, jusqu'à ce que la comparaison indique une valeur située entre lesdites valeurs minimum et maximum,
- extraction d'éléments lorsque ladite comparaison indique une valeur en deçà des valeurs minimum et maximum, jusqu'à ce que la comparaison indique une valeur située entre lesdites valeurs minimum et maximum.

## Revendications

1. Appareil électronique muni d'un synthétiseur de fréquences destiné à synthétiser des signaux dans une gamme de fréquences, synthétiseur comportant :

- un oscillateur variable à commande par grandeur électrique dont la valeur varie d'une valeur minimum vers une valeur maximum,
- une série d'éléments de modifications de l'oscillation dudit oscillateur,

caractérisé en ce qu'il est muni, en outre, d' un organe de commande pour mettre en circuit les éléments de modification en fonction de l'évolution de ladite grandeur électrique.

**2.** Appareil électronique selon la revendication 1, dans lequel ledit synthétiseur comporte :

- un oscillateur de référence
- un organe de mesure d'erreur pour comparer le signal de sortie dudit oscillateur à commande avec le signal de sortie dudit oscillateur de référence et pour former une grandeur d'erreur,

caractérisé en ce que ledit organe de commande est formé :

- d'un circuit de comparaison pour comparer ladite grandeur d'erreur avec lesdites valeur maximale et minimale ,
- d'un compteur-décompteur pour déterminer la mise en circuit ou non des éléments de modification en fonction de son contenu,
- d'un circuit logique pour mettre en position de comptage ou de décomptage ledit compteur-décompteur sous la commande dudit circuit de comparaison.

**3.** Procédé pour régler un synthétiseur de fréquence, mis en application dans un appareil électronique selon l'une des revendications 1 à 2, synthétiseur comportant :

- un oscillateur à commande par grandeur électrique dont la valeur varie d'une valeur minimum vers une valeur maximum,
- une série d'éléments de modifications de l'oscillation
- un oscillateur de référence
- un organe de mesure d'erreur pour comparer le signal de sortie dudit oscillateur à commande avec le signal de sortie dudit oscillateur de référence et pour former une grandeur d'erreur,

caractérisé en ce qu'il comporte les étapes suivantes :

- prélèvement de la valeur du signal de sortie de l'organe de mesure

-- comparaison de cette valeur avec lesdites valeurs minimum et maximum,

- insertion d'éléments lorsque ladite comparaison indique une valeur au-delà des valeurs minimum et maximum, jusqu'à ce que la comparaison indique une valeur située entre lesdites valeurs minimum et maximum,
- extraction d'éléments lorsque ladite comparaison indique une valeur en deçà des valeurs minimum et maximum, jusqu'à ce que la comparaison indique une valeur située entre lesdites valeurs minimum et maximum.

**4.** Appareil téléphonique sans fil caractérisé en ce qu'il est constitué à partir d'un appareil électronique selon l'une des revendications 1 ou 2.

FIG.1

FIG.2

**Office européen des brevets**

## RAPPORT DE RECHERCHE EUROPEENNE

Numéro de la demande

EP 99 20 0720

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | US 5 648 744 A (PRAKASH JAIDEEP ET AL) 15 juillet 1997 <br> * le document en entier * <br> --- | 1-4 | H03L7/099 <br> H03L7/10 |
| X | GB 2 120 478 A (STANDARD TELEPHONES CABLES LTD) 30 novembre 1983 <br> * page 1, ligne 1 - ligne 95; figures * <br> --- | 1-4 | |
| X | US 5 686 864 A (CARRALERO CESAR W ET AL) 11 novembre 1997 <br> * colonne 5, ligne 33 - colonne 6, ligne 32; figures 5-7 * | 1,4 | |
| A | ----- | 2,3 | |

DOMAINES TECHNIQUES RECHERCHES (Int.Cl.6)

H03L

Le présent rapport a été établi pour toutes les revendications

| Lieu de la recherche | Date d'achèvement de la recherche | Examinateur |
|---|---|---|
| LA HAYE | 4 juin 1999 | Balbinot, H |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 99 20 0720

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-06-1999

| Document brevet cité au rapport de recherche | Date de publication | Membre(s) de la famille de brevet(s) | Date de publication |
|---|---|---|---|
| US 5648744 A | 15-07-1997 | AUCUN | |
| GB 2120478 A | 30-11-1983 | DE 3313868 A | 10-11-1983 |
| US 5686864 A | 11-11-1997 | CN 1195432 A | 07-10-1998 |
| | | DE 19681546 T | 20-08-1998 |
| | | FR 2738425 A | 07-03-1997 |
| | | WO 9709786 A | 13-03-1997 |

EPO FORM P0460

Pour tout renseignement concernant cette annexe : voir Journal Officiel de l'Office européen des brevets, No.12/82